# EUROPÄISCHE PATENTSCHRIFT

(11) **EP 2 150 854 B1**
(45) Veröffentlichungstag und Bekanntmachung des Hinweises auf die Patenterteilung: **11.01.2012**
(21) Anmeldenummer: 08758604.6
(22) Anmeldetag: 17.05.2008
(51) Int. Cl.: G03F 7/00

(54) **STEMPEL FÜR DAS MIKROKONTAKTDRUCKEN UND VERFAHREN ZU SEINER HERSTELLUNG**
DIE FOR MICRO-CONTACT PRINTING AND METHOD FOR THE PRODUCTION THEREOF
POINÇON POUR IMPRESSION PAR MICROCONTACT ET SON PROCEDE DE FABRICATION

(30) Priorität: 26.05.2007 DE 102007024653
(43) Veröffentlichungstag der Anmeldung: 10.02.2010
(73) Patentinhaber: Karlsruher Institut für Technologie, 76131 Karlsruhe (DE)
(72) Erfinder: WALHEIM, Stefan, 76356 Weingarten (DE); SCHIMMEL, Thomas, 76131 Karlsruhe (DE); GRÖGER, Roland, 76646 Bruchsal (DE)
(74) Vertreter: Gärtner, Stephan
(86) Internationale Anmeldenummer: PCT/EP2008/003985
(87) Internationale Veröffentlichungsnummer: WO 2008/145268

(56) Entgegenhaltungen:
- WO-A-2005/072235
- WO-A-2006/003594
- WO-A-2006/112815
- US-A1- 2006 134 556

## Beschreibung

Die Erfindung betrifft einen Stempel für das Mikrokontaktdrucken und ein Verfahren zu seiner Herstellung.

Mikrokontaktdrucken (*Micro Contact Printing,* µCP) ist ein Verfahren zur Herstellung von zweidimensionalen Strukturen im Submikrometerbereich. Nach A. Kumar und G.M. Whitesides, Features of gold having micrometer to centimeter dimensions can be formed through a combination of stamping with an elastomeric stamp and an alkanethiol "ink" followed by chemical etching, Applied Physics Letters, Band 63, S. 2002-2004, 1993, wird hierzu das flüssige Polymer Silikon über ein strukturiertes Relief, das auch als *Master* bezeichnet wird, gegossen und ausgehärtet. Das Silikonelastomer formt die Topographie der Gussform ab und bildet einen Stempel. Der Stempel wird mit funktionalisierten Molekülen, z.B. selbstorganisierenden Alkanthiolen benetzt, die die Funktion der "Tinte" beim Stempeln übernehmen. Durch direkten Kontakt mit einem Substrat wird analog zum Hochdruckverfahren das Molekülmuster vom Stempel auf die Oberfläche des Substrats übertragen.

Mikrokontaktdrucken ist einfach und kostengünstig und wird bis zu einer Größenordnung der einzelnen Strukturen von ca. 200 nm sehr gut beherrscht. Unterhalb dieser Größe stößt das als Stempelmaterial verwendete Polydimethylsiloxan (PDMS) jedoch an seine mechanischen Grenzen. Die mögliche Auflösung ist durch die Wirkung von Adhäsion und Kapillarkräften beim Abformen und Stempeln begrenzt. Sind die Reliefstrukturen zu schlank, werden sie möglicherweise unvollständig abgeformt oder können beim Abziehen des Stempels abreißen. Strukturen mit hohem Aspektverhältnis können umkippen, zusammenkleben oder werden unter dem Druck beim Stempeln flachgedrückt. Bei niedrigem Aspektverhältnis können die Adhäsionskräfte zu einem Durchdrücken des Stempels zwischen zwei zu weit voneinander entfernten Strukturen führen. Zusätzlich können dann auch Tintenmoleküle durch die Gasphase auf die Oberfläche diffundieren.

Um Strukturen mit Abmessungen unterhalb von 100 nm zu erzeugen, wurden in den letzten Jahren verschiedene Ansätze verfolgt, die dafür jedoch Einschränkungen der Layoutmöglichkeiten für spezielle Strukturen oder die Einführung zusätzlicher komplexer Verfahrensschritte in Kauf nahmen.

H.-W. Li, B.V.O. Muir, G. Fichet, W.T.S. Huck, Nanocontact Printing, A Route to Sub-50-nm-Scale Chemical and Biological Patterning, Langmuir, Band 19, S. 1963-1965, 2003, versuchten die mechanische Stabilität durch Strukturen mit dreieckigem Querschnitt zu verbessern. Auf diese Weise wurden zwar schmalere Linien erhalten, die jedoch einen größeren Abstand zueinander haben mussten.

Um die Zwischenräume zwischen zwei gestempelten Flächen zu verkleinern, versuchten Y. Xia und G.M. Whitesides in Use of Controlled Reactive Spreading of Liquid Alkanethiol on the Surface of Gold To Modify the Size of Features Produced by Microcontact Printing, Journal of the American Chemical Society, Band 117, S. 3274-3275, 1995, ein gezieltes Ausbreiten der selbstorganisierten Moleküle während des Stempelns und in Extending Microcontact Printing as a Microlithographic Technique, Langmuir, Band 13, S. 2059-2067, 1997, eine mechanische Kompression des Stempels.

Um die Diffusion der selbstorganisierenden Moleküle durch die Gasphase auf das Substrat einzuschränken, um so unscharfe Ränder an den Strukturen zu vermeiden, wurden in L. Libioulle, A. Bietsch, H. Schmid, B. Michel, E. Delamarche, Contact-Inking Stamps for Microcontact Printing of Alkanethiols on Gold, Langmuir, Band 15, S. 300-304, 1999, die Stempel nicht getränkt, sondern in Analogie beim Einsatz eines Stempelkissens nur durch Kontakt an den aktiv stempelnden Flächen mit Molekülen benetzt.

Die EP 1 193 056 A1 offenbart einen Stempel für das Mikrokontaktdrucken aus PDMS, der eine temporär stabile hydrophile Oberfläche besitzt, die hergestellt wird, indem die Oberfläche des Stempelns aktiviert und mit einem hydrophilen Polymer versehen wird.

Die EP 1 657 070 A1 offenbart einen Stempel für das Mikrokontaktdrucken, der aus einem ionomeren Polymer besteht, und ein Verfahren zu seiner Herstellung.

Die bekannten Verfahren ermöglichen jeweils die Verkleinerung einer bestimmten Mustereigenschaft, erlauben jedoch weder einzeln noch in Kombination die Replikation beliebiger Muster mit Strukturen mit Abmessungen im Bereich unter etwa 200 nm.

Aus der DE 197 38 913 A1, der US 6,746,825 B2 und der US 2006/0134556 A1 sind Strukturen auf einem dünnen Substrat bekannt, die mittels Phasenseparation von Blockcopolymeren hergestellt werden. Diese Strukturen dienen jeweils als Templat, d.h. sie werden für einen oder mehrere weitere Schritte in einem folgenden Herstellungsverfahren geopfert. Mit diesen Strukturen alleine ist es nicht möglich, eine Vervielfältigung einer Struktur im Rahmen eines Druckverfahrens vorzunehmen.

Die WO 2006/003594 A2 offenbart einen Stempel für das Mikrokontaktdrucken, umfassend einen Stempelkörper und eine mit diesem Stempelkörper fest verbundene Stempelfläche, deren Oberfläche in mindestens zwei Bereiche aus mindestens zwei verschiedenen Materialien, deren Aufnahmefähigkeit für Stempeltinte sich unterscheidet, aufgegliedert ist, wobei mindestens einer der mindestens zwei Bereiche eine laterale Abmessung von höchstens 1000 Nanometern besitzt.

Die WO 2005/072235 A2 beschreibt ein Verfahren zur Herstellung eines Stempels für das Mikrokontaktdrucken, bei dem ein Stempel als Substratvorlage bereitgestellt wird, eine Schicht aus einer Mischung aus zwei unterschiedlichen Polymeren auf die Oberfläche des Substrats aufgebracht wird und die Schicht in mindestens zwei Phasen geordnet separiert.

Ausgehend hiervon ist es die Aufgabe der vorliegenden Erfindung, einen Stempel für das Mikrokontaktdrucken und ein Verfahren zu seiner Herstellung vorzuschlagen, die die vorher genannten Nachteile und Einschränkungen nicht aufweisen.

Insbesondere soll ein topographiefreier Stempel für das Mikrokontaktdrucken bereitgestellt werden, mit dem sich nahezu beliebige Strukturen mit Abmessungen von höchstens 1000 nm, bevorzugt 100 nm, vervielfältigen lassen und mit dem sich alle Begrenzungen, die durch die Topographie des Stempels begründet sind, überwinden lassen.

Diese Aufgabe wird im Hinblick auf den Stempel durch die Merkmale des Anspruchs 1 und im Hinblick auf ein Verfahren zu seiner Herstellung durch die Schritte des Anspruchs 7 gelöst. Die Unteransprüche beschreiben jeweils vorteilhafte Ausgestaltungen der Erfindung.

Ein erfindungsgemäßer Stempel für das Mikrokontaktdrucken weist einen Stempelkörper und eine mit ihm fest verbundene, vorzugsweise hiermit vernetzte Stempelfläche auf, wobei die Stempelfläche mindestens zwei verschiedene Materialien, die jeweils eine unterschiedliche Aufnahmefähigkeit für Stempeltinte besitzen, aufweist. Die mindestens zwei verschiedenen Materialien sind derart in mindestens zwei Bereichen angeordnet, dass besitzt mindestens einer dieser Bereiche eine laterale Abmessung von höchstens 1000 nm, bevorzugt 100 nm, besitzt.

Der Stempelkörper besteht vorzugsweise aus einem Elastomer, d.h. aus einem Material mit Molekülen, die chemisch vernetzbar sind und sich bei Raumtemperatur oberhalb ihrer Glasübergangstemperatur befinden. Hierzu gehören insbesondere Polyisopren (PI), Polybutadien (PB), Polydimethylsiloxan (PDMS), natürlicher Gummi oder thermoplastische Elastomere.

Die Stempelfläche besitzt zwei oder mehr unterschiedliche Bereiche, wobei sich vorzugsweise in einem Bereich der Stempelfläche ein Elastomer befindet. Dieses Elastomer kann sogar dasselbe Material sein, aus dem der Stempelkörper besteht. In den weiteren Bereichen der Stempelfläche befindet sich vorzugsweise ein weiteres Elastomer oder ein glasartiges Polymer, d. h. ein Polymer mit Molekülen, die sich bei Raumtemperatur unterhalb ihrer Glasübergangstemperatur befinden.

Erfindungsgemäß ist die Stempelfläche aus einer Polymermischung oder aus einem Blockcopolymer gebildet, deren Bestandteile so ausgewählt sind, dass sie jeweils eine unterschiedliche Aufnahmefähigkeit für Stempeltinte besitzen.

Besonders bevorzugt ist hierbei ein Blockcopolymer, das als ein Bestandteil Polyisopren, Polybutadien oder Polydimethylsiloxan enthält, insbesondere Polyethylenoxid-b-Polyisopren-b-Polyethylenoxid (PEO-PI-PEO) oder Polystyrol-b-Polybutadien-b-Polystyrol (SBS).

Als Tinte eignen sich die für das Mikrokontaktdrucken bekannten Tinten. Der Einsatz von hydrophilen Tinten wird durch die Anwesenheit hydrophiler Stempelbereiche ermöglicht. Der Stempel muss daher nicht wie bei einem Stempel aus reinem PDMS gesondert hydrophilisiert werden.

Im Unterschied zum Stand der Technik ist der erfindungsgemäße Stempel für das Mikrokontaktdrucken topographiefrei; d.h. die Vervielfältigung des eingeprägten Musters erfolgt nicht über Strukturen, die unterschiedliche Höhen über der Stempelfläche aufweisen, sondern über eine ebene Fläche, die in Bereiche mit jeweils unterschiedlicher Aufnahmefähigkeit für Stempeltinte aufgegliedert ist. Durch das praktisch fast vollständige Fehlen von Topographie lassen sich die Einschränkungen des klassischen Mikrokontaktdruckens überwinden.

Diejenigen Flächen des Stempels, die keine Tinte aufnehmen, stützen zum einem den Stempel gegen das Substrat ab und versiegeln zum anderen die Oberfläche gegen unerwünschte Diffusion von Tinte. Auf diese Weise lassen sich einerseits Probleme, die durch die mechanische Belastung der topographischen Strukturen verursacht werden, überwinden. Andererseits werden damit Muster mit nur wenig zu bestempelnder Fläche möglich.

Ein erfindungsgemäßer Stempel für das Mikrokontaktdrucken lässt sich insbesondere mit dem folgenden Verfahren herstellen.

Gemäß Verfahrensschritt a) wird zunächst ein Substrat als Stempelvorlage bereitgestellt. In einer bevorzugten Ausgestaltung dient hierfür ein ebener Silizium-Wafer.

Anschließend wird gemäß Verfahrensschritt b) die Oberfläche des Substrats so strukturiert, dass die Oberfläche in mindestens zwei Bereiche mit verschiedenen chemischen Eigenschaften unterteilt wird, und eine Schicht aus mindestens zwei unterschiedlichen Polymeren oder aus einem Blockcopoymer auf die strukturierte Oberfläche des Substrats aufgebracht, wodurch die Schicht entsprechend den mindestens zwei Bereichen in mindestens zwei Phasen geordnet separiert.

Die chemisch heterogene Strukturierung erfolgt vorzugsweise mit einem Rastersondenverfahren, insbesondere mit einem Rasterkraftmikroskop (Atomic Force Microscope, AFM), mit Elektronenstrahl-, UV-, Röntgeninterferenz- oder Imprint-Lithographie. Dabei werden in einer Monolage selbstorganisierte Moleküle oder Polymerbürstenmoleküle entfernt oder ersetzt.

Alternativ wird eine dünne Oxidschicht durch Behandlung mit Fluorwasserstoff entfernt. Die auf diese Weise entstehenden Muster sollten möglichst wenig Topographie, aber einen starken chemischen Kontrast aufweisen.

In einer bevorzugten Ausgestaltung wird dann auf der Stempelfläche die Phasenseparation von phasenseparierenden Polymermischungen oder Blockcopolymerschichten als Selbstorganisationsprozess eingesetzt. Diese wird durch lateral chemisch heterogen strukturierte Substrate gesteuert.

Die auf diese Weise strukturierten Oberflächen weisen einen starken Polaritätskontrast auf, um eine Anordnung der Polymermorphologie zu gewährleisten. Hierfür eignen sich selbstorganisierende Monolagen wie Silane auf Oxiden, Thiole auf Münzmetall-Oberflächen oder so genannte *Polymerbürsten,* d.h. kurze Polymermoleküle, die an das Substrat gebunden sind.

Im sich hierzu anschließenden Verfahrensschritt c) wird zunächst ein Material aufgebracht, aus dem ein Stempelkörper gebildet wird. Durch Vernetzen des so gebildeten Stempelkörpers mit der Schicht bildet sich ein stabiler Stempel aus, bei dem die Schicht die fest mit dem Stempelkörper verbundene Stempelfläche bildet.

Schließlich wird gemäß Verfahrensschritt d) der Stempelkörper zusammen mit der als Stempelfläche dienenden Schicht vom Substrat abgehoben.

In einer bevorzugten Ausgestaltung wird die phasenseparierte Schicht mit einem Polyisopren-Stempelkörper vernetzt und anschließend gemäß Schritt d) gemeinsam vom zurückbleibenden Substrat abgehoben. Vorzugsweise bleibt dabei das ursprüngliche Substrat intakt und kann für die Herstellung von weiteren Stempeln eingesetzt werden.

Ein erfindungsgemäßer Stempel eignet sich für das Mikrokontaktdruck-Verfahren. Zum Stempeln wird die Stempelfläche, die zwei Materialien mit unterschiedlicher Aufnahmefähigkeit für Stempeltinte aufweist, mit einer Tinte getränkt. Die Moleküle aus der Tinte diffundieren bevorzugt in eine der beiden Phasen. Wird danach der Stempel auf eine Unterlage aufgedrückt, replizieren die Moleküle aus der getränkten Phase der Schicht das zuvor strukturierte Muster in Form einer selbstorganisierten Monolage auf der Oberfläche.

Insbesondere der erfindungsgemäße Einsatz von Blockcopolymeren und des Rasterkraftmikroskops (AFM) schafft die Voraussetzungen dafür, um nahezu beliebig aufwändige zweidimensionale Muster auch mit Größenordnungen von höchstens 1000 nm in eine Schicht zu übertragen.

Die Erfindung wird im Folgenden anhand von Ausführungsbeispielen und den Figuren näher erläutert. Hierbei zeigen:
- **Fig. 1**: Mikrokontaktdruck-Verfahren (Stand der Technik)
- **Fig. 2**: Im Mikrokontaktdruck-Verfahren auftretende Probleme
- **Fig. 3**: Herstellung eines erfindungsgemäßen Stempels für das Mikrokontaktdrucken und Mikrokontaktdruck-Verfahren
- **Fig. 4**: Lamellare Morphologie der PEO-PI-PEO-Schicht auf einer selbstorganisierten Monolage aus OTS vor **(a)** bzw. nach **(b)** der Stempelherstellung
- **Fig. 5**: Stempel **(a)** und mit diesem Stempel durch Mikrokontaktdruck-Verfahren hergestellte Struktur **(b)**

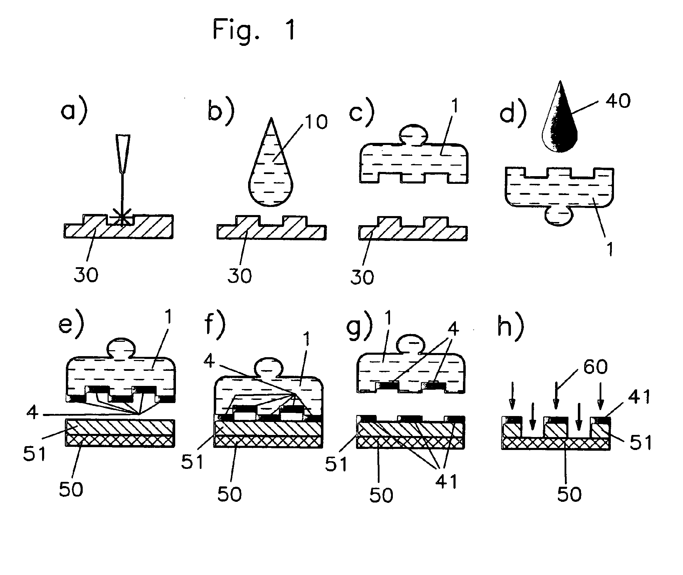

In **Fig. 1** zeigt schematisch das aus dem Stand der Technik bekannte Mikrokontaktdruck-Verfahren. Von einer lithographisch strukturierten Form **30,** die eine reliefartig geformte Oberfläche aufweist und als Stempelvorlage dient **(****Fig. 1a****),** wird durch Abgießen der Form mit dem Silikon **10** Polydimethylsiloxan (PDMS) **(****Fig. 1b****)** ein Silikonstempel **1** abgeformt **(****Fig. 1c****).**

Zum Drucken wird der Stempel **1** mit Molekülen **40** benetzt **(****Fig. 1d****),** die in Bereiche **4** der reliefartig geformten Stempelfläche des Stempels **1** eindringen **(****Fig. 1e****).** Durch direkten Kontakt bildet sich an den vorstehenden Flächen als Muster eine selbstorganisierte Monolage **41** auf einem Substrat **51,** das z.B. eine Metalloberfläche sein kann, auf einem Träger **50 (****Fig. 1f****).** Nach Abheben des Stempels **1 (****Fig. 1g****)** kann das auf dem Substrat **51** anhaftende Muster aus der selbstorganisierten Monolage **41** z.B. als Resist in einem Ätzverfahren **60** dienen, das das Substrat **51** ätzt. **(****Fig. 1h****).**

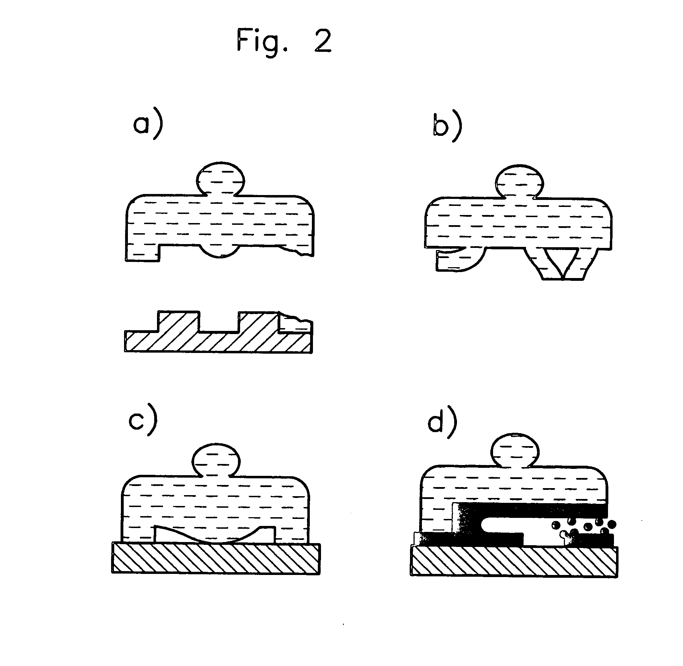

In **Fig. 2** sind die Probleme des Mikrokontaktdruck-Verfahrens bei hoher Auflösung dargestellt:
- Feine Strukturen werden schlecht abgeformt werden oder reißen beim Abziehen **(****Fig. 2a****).**
- Sehr schmale Stege auf dem Stempel können umkippen oder zusammenkleben **(****Fig. 2b****).**
- Große Zwischenräume lassen sich beim Stempeln leicht durchdrücken **(****Fig. 2c****).**
- Bei niedrigem Aspektverhältnis gelangt die Tinte durch Kapillarwirkung oder Diffusion auf der Oberfläche oder durch die Gasphase unspezifisch auf die Probe und breitet sich dort aus **(****Fig. 2d****).**

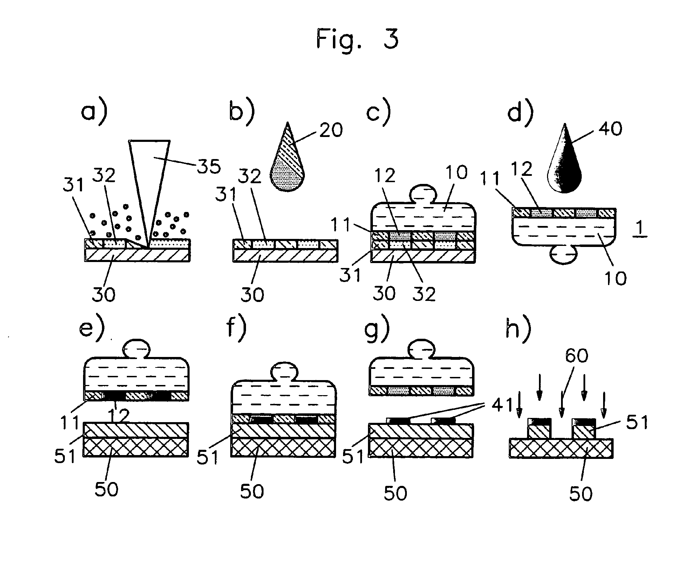

**In** **Fig. 3** sind die Herstellung eines erfindungsgemäßen Stempels für das Mikrokontaktdrucken und das damit durchgeführte Mikrokontaktdruck-Verfahren schematisch dargestellt.

### 1. Präparation des Substrats

Als Substrat **30** für die Stempelvorlage dienten Siliziumwafer mit natürlich oxidierten polierten Oberflächen. Die Wafer wurden in passende Stücke geschnitten und mit einem Kohlendioxid-Schneestrahl (*Snow-Jet*) gereinigt. Durch Eintauchen in reines OTS oder in eine OTS-haltige n-Hexan-Lösung wurde die Oberfläche wurde mit einer selbstorganisierenden Monolage (SAM) aus Oktadekyltrichlorsilan (OTS) beschichtet.

Die Silanmoleküle banden unter Abspaltung der Chloratome kovalent an die Siliziumoberfläche und bildeten eine dichte Monolage. Die Schichtdicke betrug 2,4 nm und die chemische Funktionalisierung wurde durch die unpolare CH₃-Endgruppe des Moleküls gebildet. Nach der Beschichtung wurden die Proben erneut mit dem Kohlendioxid-Schneestrahl gereinigt. Die OTS-Schicht erwies sich als stabil gegenüber dieser Behandlung.

### 2. Strukturierung des Substrats

Die Monolage aus OTS wurde gemäß **Fig. 3a** mit einem Rasterkraftmikroskop (AFM) nanoskalig lateral heterogen chemisch strukturiert. Bei geeigneter Wahl der Auflagekraft löste die Spitze **35** des AFM die an die Oberfläche gebundenen Moleküle der Monolage bzw. des Brush ab, ohne das Substrat zu modifizieren. Diese Art des Vorgehens wird auch *Nanoshaving oder Molecular Editing* genannt. Die Strukturierung wurde mit einem AFM entweder trocken an Luft oder in einer Flüssigkeitszelle in Lösung durchgeführt.

Beim Entfernen der Moleküle während der Strukturierung verbleibt die Silizium-Kopfgruppe des Silans auf dem Substrat und nur die Alkankette wird abgetrennt, während die verbleibenden Kopfgruppen eine zusätzliche SiOₓ-Monolage ausbilden. Die abgetrennten Alkanketten können dagegen nicht wieder an die Oberfläche binden. Auf diese Weise entsteht in einer unpolaren Umgebung ein chemischer Kontrast, bei dem die editierten Bereiche polar sind.

Die mit diesem Verfahren hergestellten Muster aus den Bereichen **31, 32** können sehr komplex sein. In der Praxis sind Einschränkungen nur durch die Größe des Scanbereichs des Strukturierungsmikroskops und bei größeren Strukturen durch die Abnutzung der Spitze **35** des AFM gegeben. Die Linien können beliebige Abstände aufweisen, ebenso können beliebige Flächen strukturiert werden. Die Linienbreite selbst ist durch den Radius der Spitze **35** des AFM vorgegeben.

Nach der Strukturierung wurde die Probe erneut mit dem Kohlendioxid-Schneestrahl gereinigt.

### 3. Präparation des Blockcopolymer-Films

Als Polymer diente Polyethylenoxid-b-Polyisopren-b-Polyethylenoxid (PEO-PI-PEO), das aus drei zusammenhängenden Polymerblöcken mit molaren Massen von m_{PEO} = 12,3 kg/mol und m_{PI} = 43,4 kg/mol besteht. Die PEO-Komponente ist polar, während die PI-Komponente unpolar ist.

Ein Tropfen 1%iger Lösung **20** dieses Polymers in Toluol wurde gemäß **Fig. 3b** auf die in die Bereiche **31, 32** strukturierte Probe getropft, wo das Toluol bei Umgebungsbedingungen verdampft. Die Menge wurde so gewählt, dass eine etwa 100 nm dicke Schicht entsteht. Beim Eindampfen trennten sich die verschiedenen Blöcke des Blockcopolymers durch ihre abstoßende Wechselwirkung in geordnete phasenseparierte Bereiche **11, 12** auf. Dadurch ordneten sich die Blöcke je nach Polarität an die entsprechenden Strukturen der Probe an: Das polare PEO zu den polaren Bereichen **31** z. B. aus Siliziumdioxid und das unpolare PI zu den unpolaren Bereichen **32.** z.B. zum CH₃-terminierten OTS.

Um die Anordnung nach dem Eindampfen noch zu verbessern, wurde die Probe einige Zeit einem Toluoldampf ausgesetzt. Dieses Verfahren wird als *Vapour Annealing* bezeichnet und fördert die Diffusion der Polymermoleküle in der Schicht und die Relaxation des Systems in das thermodynamische Gleichgewicht.

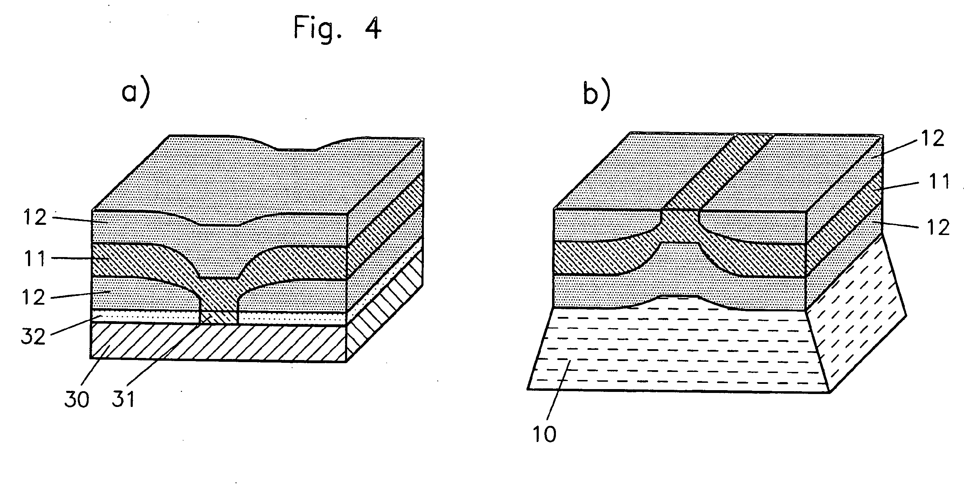

**Fig. 4a** zeigt die lamellare Morphologie der Schicht aus dem phasenseparierten Blockcopolymer PEO-PI-PEO auf einem strukturierten Templat vor der Herstellung des Stempels **1.** Auf den Bereichen **32** lagerte sich die PI-Komponente des Blockcopolymers an, während die PEO-Lamelle auf den Bereichen **31** haftet.

### 4. Herstellung des Stempels

Als Stempelmaterial **10** diente flüssiges synthetisches Polyisopren, das entsprechend **Fig. 3c** direkt auf das Substrat **30** vulkanisiert wurde, das mit der in die Bereiche **11, 12** phasenseparierte Polymerschicht und den Bereichen **31, 32** belegt war.

Hierzu wurde das flüssige Polyisopren mit 10 Gew.% Dicumylperoxid (DCPO) gemischt, auf die Probe aufgetropft und für 1 h in einem Tiegel unter Vakuum bei 150 °C gehalten. Um die Reißfestigkeit des Materials zur Ablösung vom Substrat vorübergehend zu erhöhen, wurde die Probe nach der Vulkanisierung einige Zeit auf -20 °C gekühlt.

Danach ließ sich der vernetzte Polyisoprenstempel abziehen, ohne Rückstände auf dem strukturierten Substrat zu hinterlassen. Die Blockcopolymerschicht wurde mit von der Probenoberfläche abgezogen, da die PI-Blöcke der Schicht mit an den Stempel vulkanisiert waren. Das ursprüngliche Substrat blieb dabei intakt und konnte für die Herstellung von weiteren Stempeln eingesetzt werden.

Das ausgewählte Blockcopolymer besitzt die spezielle Eigenschaft, dass sich die Phasenseparation nicht lateral, sondern vertikal ausrichtet. Dadurch sind flächenhaft abwechselnd stempelnde und abschirmende Bereiche möglich. **Fig. 4b** zeigt, dass sich bei der Herstellung des Stempels mit einem Stempelkörper aus PI die Morphologie der Blockcopolymerschicht und die Breite der Domäne aus PEO entlang der strukturierten Linie nicht verändern.

In einem weiteren Versuch wurde auf die phasenseparierte Polymerschicht durch Aufgießen und Trocknenlassen von in Toluol gelösten Blockcopolymer Polystyrol-b-Polybutadien-b-Polystyrol (SBS) ein Stempelkörper aus SBS aufgebracht.

### 5. Durchführung des Stempelns

Zum Stempeln wurde die nun an der Unterseite des Stempels 1 befindliche phasenseparierte Blockcopolymerschicht **11, 12** gemäß **Fig. 3d** mit einer Lösung mit Alkanthiolen (ODT) getränkt. Die ODT-Moleküle diffundierten gemäß **Fig. 3e** bevorzugt in die viskoelastische Phase **12.** Danach wurde der Stempel gemäß **Fig. 3f** auf eine Goldschicht **51** auf einem Siliziumsubstrat aufgedrückt, wobei die ODT-Moleküle aus der getränkten Phase **12** der Schicht das zuvor strukturierte Muster in Form einer selbstorganisierten Monolage **14** auf der Oberfläche der Goldschicht **51** replizieren **(****Fig. 3g****),** das auch hier z.B. als Resist in einem Ätzverfahren 60 dienen kann, das die Goldschicht **51** ätzt **(****Fig. 3h****).**

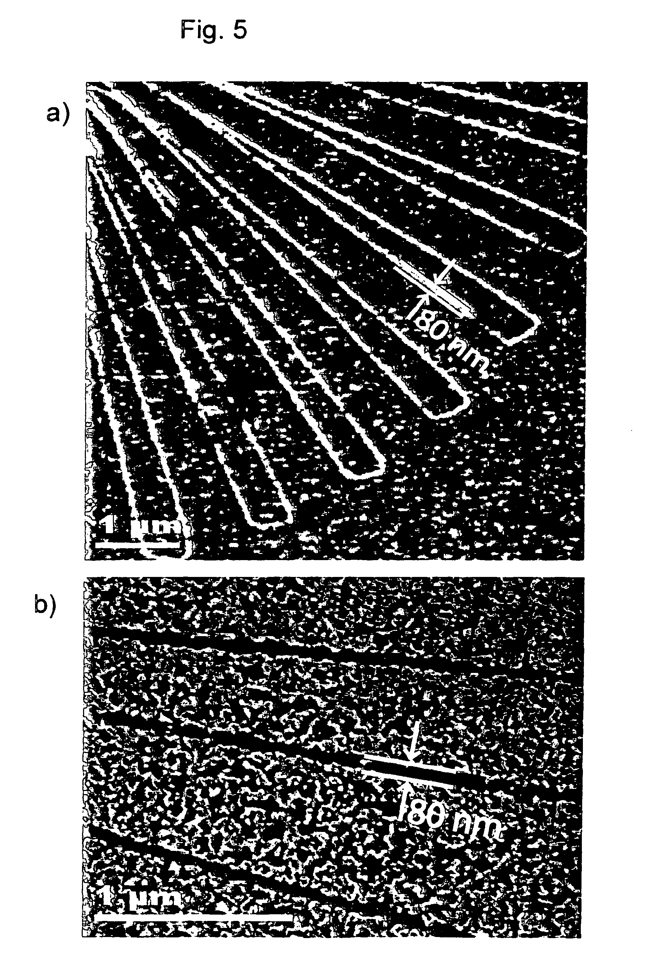

**Fig. 5a** zeigt ein mit einem Rasterkraftmikroskop (AFM) aufgenommenes Phasenkontrastbild einer Radstruktur in der Blockcopolymerschicht auf der Stempelunterseite. Die Linienbreite wurde an verschiedenen Stellen zu 80 nm bestimmt.

**Fig. 5b** zeigt eine rasterelektronenmikroskopische Aufnahme einer Goldschicht, die mit dem Stempel aus **Fig. 5a** gestempelt und dann geätzt wurde. Die Linien der geätzten Goldstruktur waren mit 80 nm genau so breit wie die Linien auf dem Stempel.

## Patentansprüche

1. Stempel (1) für das Mikrokontaktdrucken, umfassend einen Stempelkörper (10) und eine mit diesem Stempelkörper (10) fest verbundene Stempelfläche, deren Oberfläche in mindestens zwei Bereiche (11, 12) aus mindestens zwei verschiedenen Materialien, deren Aufnahmefähigkeit für Stempeltinte sich unterscheidet, aufgegliedert ist, wobei mindestens einer der mindestens zwei Bereiche eine laterale Abmessung von höchstens 1000 Nanometern besitzt, **dadurch gekennzeichnet, dass** die mindestens zwei Bereiche auf der Oberfläche der Stempelfläche aus einer in ihre Phasen geordnet separierte Polymermischung oder einem Blockcopolymer gebildet sind.

2. Stempel nach Anspruch 1, **dadurch gekennzeichnet, dass** mindestens einer der mindestens zwei Bereiche eine laterale Abmessung von höchstens 100 Nanometern besitzt.

3. Stempel nach Anspruch 1 oder 2, **dadurch gekennzeichnet, dass** der Stempelkörper (10) aus einem Elastomer besteht.

4. Stempel nach Anspruch 3, **dadurch gekennzeichnet, dass** die mindestens zwei Bereiche auf der Oberfläche der Stempelfläche derart aufgegliedert sind, dass mindestens ein Bereich dasselbe Material wie der Stempelkörper aufweist und mindestens ein anderer Bereich ein anderes Elastomer oder ein Polymer aufweist.

5. Stempel nach einem der Ansprüche 1 bis 4, **dadurch gekennzeichnet, dass** das Blockcopolymer als ein Bestandteil Polyisopren, Polybutadien oder Polydimethylsiloxan enthält.

6. Stempel nach Anspruch 5, **dadurch gekennzeichnet, dass** das Blockcopolymer als ein Bestandteil Polyethylenoxid-b-Polyisopren-b-Polyethylenoxid oder Polystyrol-b-Polybutadien-b-Polystyrol enthält.

7. Verfahren zur Herstellung eines Stempels (1) für das Mikrokontaktdrucken gemäß einem der Ansprüche 1 bis 6 mit den Schritten
a) Bereitstellen eines Substrats (30) als Stempelvorlage,
b) Strukturieren einer Oberfläche des Substrats (30), so dass die Oberfläche in mindestens zwei Bereiche (31, 32) mit unterschiedlichen chemischen Eigenschaften unterteilt wird, und Aufbringen einer Schicht aus einem Blockcopolymer oder aus einer Mischung aus mindestens zwei unterschiedlichen Polymeren auf die strukturierte Oberfläche des Substrats, wodurch die Schicht entsprechend den mindestens zwei Bereichen (31, 32) in mindestens zwei Phasen (11, 12) geordnet separiert,
c) Aufbringen eines Materials, aus dem der Stempelkörper (10) gebildet wird, und Vernetzen des Stempelkörpers (10) mit der dem Substrat (30) abgewandten Seite der Schicht,
d) Abheben des Stempelkörpers (10) mit der als Stempelfläche dienenden Schicht vom Substrat (30).

8. Verfahren nach Anspruch 7, wobei die Oberfläche des Substrats (30) vor Schritt b) mit einem Rastersondenverfahren oder einem Lithographieverfahren strukturiert wird.

9. Verfahren nach Anspruch 7 oder 8, wobei die Oberfläche des Substrats (30) vor Schritt b) mit einer selbstorganisierenden Monolage versehen wird.

## Claims

1. A stamp (1) for microcontact printing, comprising a stamp body (10) and a stamp face which is firmly connected to said stamp body (10) and whose surface is subdivided into at least two regions (11, 12) made of at least two different materials with different absorbencies for stamp ink, wherein at least one of the at least two regions has a lateral dimension of a maximum of 1000 nanometers, **characterised in that** the at least two regions on the surface of the stamp face are formed by a polymer mixture separated into its phases in an ordered manner, or by a block copolymer.

2. A stamp according to claim 1 **characterised in that** at least one of the at least two regions possesses a lateral dimension of a maximum of 100 nanometers.

3. A stamp according to claim 1 or 2 **characterised in that** the stamp body (10) consists of an elastomer.

4. A stamp according to claim 3, **characterised in that** the at least two regions on the surface of the stamp face are subdivided such that at least one region exhibits the same material as the stamp body and that at least one other region exhibits another elastomer or a polymer.

5. A stamp according to any one of claims 1 to 4 **characterised in that** the block copolymer contains polyisoprene, polybutadiene or polydimethylsiloxane as a constituent.

6. A stamp according to claim 5, **characterised in that** the block copolymer contains poly(ethylene oxide)-b-polyisoprene-b-poly(ethylene oxide) or poly(styrene-b-polybutadiene-b-polystyrene) as a constituent.

7. A method for producing a stamp (1) for microcontact printing according to any one of claims 1 to 6 with the following steps
a) providing a substrate (30) as stamp template,
b) texturing a surface of the substrate (30) so that the surface is subdivided into at least two regions (31, 32) having different chemical properties, and applying a film made of a block copolymer or of a mixture of at least two different polymers onto the textured surface of the substrate, whereby the film is separated in an ordered manner into at least two phases (11, 12) according to the at least two regions (31, 32),
c) applying a material from which the stamp body (10) is formed, and networking the stamp body (10) with the side of the film facing away from the substrate (30),
d) peeling the stamp body (10) with the film serving as the stamp surface off the substrate (30).

8. A method according to claim 7 wherein the surface of the substrate (30) is textured with a scanning probe method or a lithography method before step b).

9. A method according to claim 7 or 8 wherein the surface of the substrate (30) is provided with a self-assembling monolayer before step b).

## Revendications

1. Poinçon (1) pour l'impression par microcontact comportant un corps de poinçon (10) et une surface de poinçon fixée rigidement à ce corps de poinçon (10) et dont la surface est subdivisée en au moins deux zones (11, 12) en au moins deux matériaux différents dont l'aptitude à la réception de l'encre de poinçonnage diffère, au moins l'une des deux zones ayant une étendue latérale d'au plus 1000 nanomètres,
**caractérisé en ce que**
les au moins deux zones sont formées sur la surface de la surface de poinçon à partir d'un mélange de polymères séparés à phases séquencées ou d'un copolymère bloc.

2. Poinçon conforme à la revendication 1,
**caractérisé en ce qu'**
au moins l'une des au moins deux zones, a une extension latérale d'au plus 100 nanomètres.

3. Poinçon conforme à la revendication 1 ou 2,
**caractérisé en ce que**
le corps de poinçon (10) est en un élastomère.

4. Poinçon conforme à la revendication 3,
**caractérisé en ce qu'**
les au moins deux zones de la surface de la surface de poinçon, sont subdivisées de sorte qu'au moins une zone comporte le même matériau que le corps de poinçon et qu'au moins une autre zone comporte un autre élastomère ou un polymère.

5. Poinçon conforme à l'une quelconque des revendications 1 à 4,
**caractérisé en ce que**
le copolymère bloc renferme en tant que constituant du polyisoprène, du polybutadiène ou du polydiméthylsiloxane.

6. Poinçon conforme à la revendication 5,
**caractérisé en ce que**
le copolymère bloc renferme en tant que constituant, du polyéthylène-oxyde-b-polyisoprène-b-polyéthylène-oxyde ou du polystyrène-b-polybutadiène-b-polystyrène.

7. Procédé d'obtention d'un poinçon (1) pour l'impression par microcontact conforme à l'une des revendications 1 à 6, comportant les étapes consistant à :
a) Préparer un substrat (30) en tant qu'ébauche de poinçon ;
b) Structurer une surface du substrat (30) de sorte que cette surface soit subdivisée en au moins deux zones (31, 32) ayant des propriétés chimiques différentes, et application d'une couche en un copolymère bloc ou en un mélange d'au moins deux polymères différents sur la surface structurée du substrat, par suite de quoi, la couche est séparée selon les au moins deux zones (31, 32) en au moins deux phases séquencées (11, 12) ;
c) Application d'un matériau à partir duquel le corps de poinçon (10) est formé et réticulation du corps de poinçon (10) avec la face de la couche située à l'opposé du substrat (30) ;
d) Séparation du corps de poinçon (10) avec la couche faisant office de surface de poinçon du substrat (30).

8. Procédé conforme à la revendication 7,
selon lequel
avant l'étape b), la surface du substrat (30) est structurée par un procédé de scannage d'échantillons ou de lithographie.

9. Procédé conforme à la revendication 7 ou 8,
selon lequel
avant l'étape b), la surface du substrat (30) est pourvue d'une mono-couche auto-organisatrice.
